# EUROPEAN PATENT APPLICATION

(11) **EP 4 439 650 A1**
(43) Date of publication of application: **02.10.2024**
(21) Application number: 23212798.5
(22) Date of filing: 28.11.2023
(51) Int. Cl.: H01L 23/15, H01L 23/498, H01L 23/522, H01L 23/64, H01L 23/66

(54) **GLASS-INTEGRATED INDUCTORS IN INTEGRATED CIRCUIT PACKAGES**

(30) Priority: 30.03.2023 US 202318193172
(71) Applicant: INTEL Corporation, Santa Clara, CA 95054 (US)
(72) Inventor: MISHRA, Pratyush, Tempe, 85283 (US); WALL, Marcel, Phoenix, 85048 (US); KANDANUR, Sashi, Chandler, 85226 (US); TADAYON, Pooya, Portland, 97225 (US); PIETAMBARAM, Srinivas, Chandler, 85249 (US); DUONG, Benjamin, Phoenix, 85044 (US); NAD, Suddhasattwa, Chandler, 85249 (US)
(74) Representative: HGF

(57) **Abstract**

Glass-integrated inductors in integrated circuit (IC) packages are disclosed. A disclosed IC package includes a glass layer having an aperture extending therethrough, and an inductor in the aperture, the inductor including a metal core extending through the aperture, the metal core electrically coupled to interconnects on opposite sides of the glass layer, and at least one of a ferrite or a magnetic alloy in the aperture and laterally surrounding the metal core.

## Description

### FIELD OF THE DISCLOSURE

This disclosure relates generally to integrated circuit (IC) packages and, more particularly, to glass-integrated inductors in IC packages.

### BACKGROUND

Some known integrated circuit (IC) packages utilize voltage regulators for power delivery applications. In particular, the voltage regulators can be integrated onto a package substrate as layers. However, with reduced volume for such regulators, performance and quality factors can be reduced.

### BRIEF DESCRIPTION OF THE DRAWINGS

FIG. 1 is a cross-sectional view of an example semiconductor package in accordance with teachings of this disclosure.
FIG. 2A is a detailed cross-sectional view of an example inductor in accordance with teachings of this disclosure.
FIG. 2B depicts alternative example aperture shapes in which examples disclosed herein can be implemented.
FIG. 3 is a detailed cross-sectional view of another example inductor in accordance with teachings of this disclosure.
FIG. 4 is a detailed cross-sectional view of yet another example inductor in accordance with teachings of this disclosure.
FIGS. 5A-5F are cross-sectional views illustrating an example method to produce examples disclosed herein.
FIGS. 6A-6F are cross-sectional views illustrating another example method to produce examples disclosed herein.
FIG. 7 is a flowchart representative of an example method to produce examples disclosed herein.
FIG. 8 is a flowchart representative of another example method to produce examples disclosed herein.
FIG. 9 is a top view of a wafer including dies that may be included in an IC package constructed in accordance with teachings disclosed herein.
FIG. 10 is a cross-sectional side view of an IC device that may be included in an IC package constructed in accordance with teachings disclosed herein.
FIG. 11 is a cross-sectional side view of an IC package that may include glass-integrated inductors, in accordance with teachings disclosed herein.
FIG. 12 is a cross-sectional side view of an IC device assembly that may include an IC package constructed in accordance with teachings disclosed herein.
FIG. 13 is a block diagram of an example electrical device that may include an IC package constructed in accordance with teachings disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified in the below description.

As used herein "substantially real time" refers to occurrence in a near instantaneous manner recognizing there may be real world delays for computing time, transmission, etc. Thus, unless otherwise specified, "substantially real time" refers to real time +/-1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

### DETAILED DESCRIPTION

Glass-integrated inductors in (IC) packages are disclosed. In known implementations, IC packages utilize integrated voltage regulators for power delivery applications, such as Fully Integrated Voltage Regulators (FIVR) packages. Inductors of the FIVR packages are typically integrated in package substrates. However, with generational reductions in volume and/or space available for these integrated inductors, the quality factor and the conversion efficiency of the FIVR inductors can decrease.

Magnetic materials with relatively high permeability and relatively low loss can be implemented in magnetic inductors to increase inductance, conversion efficiency and quality factor in comparison to traditional air core inductors (ACls). Further, "soft" ferrites can offer relatively high permeability with a relatively low loss. In known implementations, depositing a ferrite layer and/or structure with a thickness that exceeds a few microns onto a substrate can pose significant processing challenges, as well as structural and magnetic property degradation.

Glass substrates (e.g., glass cores) have been implemented onto IC/semiconductor packages for improved radio frequency (RF) performance. The glass substrates can be implemented in an IC/semiconductor package as a layer with interconnects extending therethrough. According to examples disclosed herein, the glass substrates may include quartz, fused silica, and/or borosilicate glass. In accordance with the present disclosure, glass substrates comprise at least one glass layer and do not comprise an epoxy-based prepreg layer with glass cloth. In operation, the glass substrates can provide high frequency performance due to lower loss and improved signal isolation.

Examples disclosed herein utilize layered (e.g., diametrically layered) magnetic inductor structures (e.g., ferrous magnetic inductor structures) that are fabricated/integrated into glass cores/substrates. Examples disclosed herein can improve inductor performance while advantageously benefiting from utilization of glass core technology. Some examples disclosed herein have improved permeability with relatively low loss by utilizing magnetic metal alloys (e.g., metal alloys with iron content). Some examples disclosed herein can also enable reduced thicknesses of IC packages by integrating inductive elements into glass as opposed to layers of a package substrate. Further, examples disclosed herein can be produced and/or implemented in a cost-effective manner while enabling improved inductor performance.

Examples disclosed herein include a conductive core that can be at least partially composed of copper. The conductive core extends along a longitudinal length of an aperture (e.g., a through hole) of a glass core/substrate. In turn, the core is surrounded laterally and/or diametrically by at least one of a ferrite or a magnetic alloy. The ferrite may include a nickel zinc ferrite (e.g., NiₐZn₍₁₋ₐ₎Fe2O₄), a manganese ferrite (e.g., MnₐZn₍₁₋ₐ₎Fe₂O₄ or a cobalt ferrite (e.g., CoFe₂O₄, CoO· Fe₂O₃). In particular, the ferrite can include nickel, zinc, manganese, cobalt, iron, iron oxide, etc. The magnetic alloy can include iron, nickel and/or cobalt, etc. Additionally or alternatively, the magnetic alloy can include a nickel-iron ferromagnetic alloy. However, any other appropriate materials, elements compounds and/or alloys can be implemented instead. In examples where the magnetic alloy is implemented, a dielectric material and/or layer can also be placed near or adjacent to the magnetic alloy. In some such examples, the dielectric material and/or layer can be placed between the aforementioned core and the magnetic alloy. In some examples, multiple ferrites and/or magnetic alloy layers are implemented to control a thickness (e.g., a diametric thickness) of magnetic integrated inductors onto a glass core/substrate. In some such examples, the different layers can be different or the same from one another (e.g., different ferrites, different magnetic alloys, different materials, etc.). Additionally or alternatively, parameters of inductive properties are controlled and/or varied based on materials, layering arrangements (e.g., diametric layering arrangements) of ferrites (e.g., ferrite layers) and/or utilization of magnetic alloy structures (e.g., magnetic alloy rings, magnetic alloy layers).

As used herein, the term "ferrite" refers to a compound including iron and/or a form of iron, nickel or cobalt suspended in a substrate. Accordingly, the term "ferrite" can refer to a ceramic-based ferrite. Further, the substrate can include silicon or alumina or any other appropriate material. As used herein, the terms "magnetic alloy" and "magnetic metal alloy" refer to a metal alloy that includes at least one of iron (or a form of iron), nickel or cobalt in addition to other metals. As used herein, the terms "laterally surrounding" and "lateral arrangement" refer to a lateral or diametric surrounding structure that surrounds an inner structure such that an inner surface of the surrounding structure faces the inner structure.

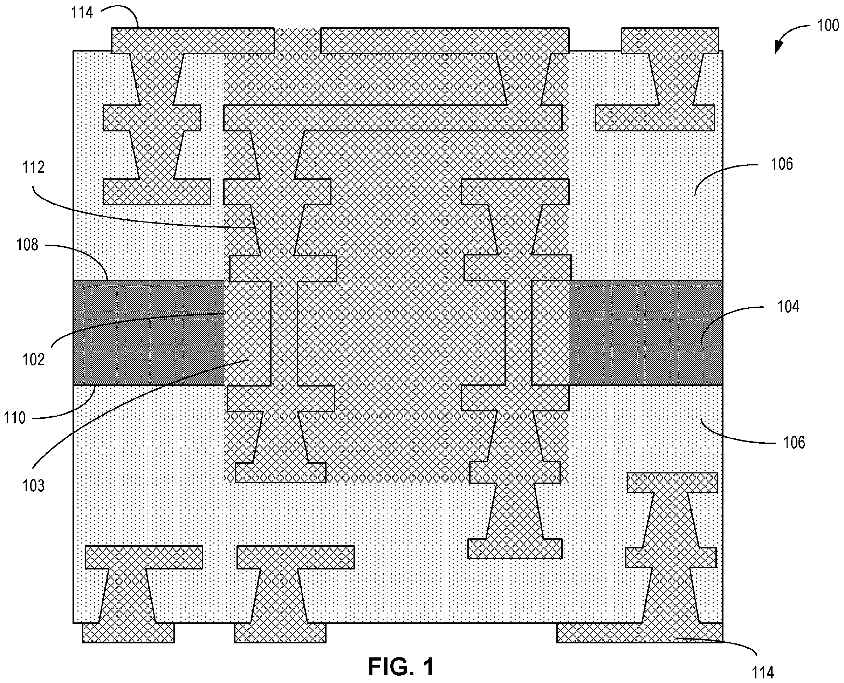

FIG. 1 is a cross-sectional view of an example semiconductor package 100 in accordance with teachings of this disclosure. In the illustrated example of FIG. 1, the semiconductor package (e.g., a glass core semiconductor package, an integrated circuit (IC) package, a glass substrate package, etc.) 100 includes an inductor (e.g., a glass-integrated inductor) 102 that is positioned in (e.g., disposed in, embedded in, integrated in, etc.) an aperture (e.g., a through hole) 103 of a glass substrate (e.g., a glass core, a glass layer, a layered glass structure, etc.) 104. In turn, dielectric layers (e.g., insulative dielectric layers) 106 are positioned coupled to the glass substrate 104 at a first side 108 and at a second side 110 of the glass substrate 104 (opposite of the first side 108). The glass substrate 104 may include quartz, fused silica, and/or borosilicate glass. In the illustrated example of FIG. 1, the glass substrate 104 includes at least one glass layer and does not include an epoxy-based prepreg layer with glass cloth. In this example, interconnects 112 at least partially extend through the dielectric layers 106 and, in turn, pads (e.g., solder pads, contact pads, die interconnect pads, etc.) 114.

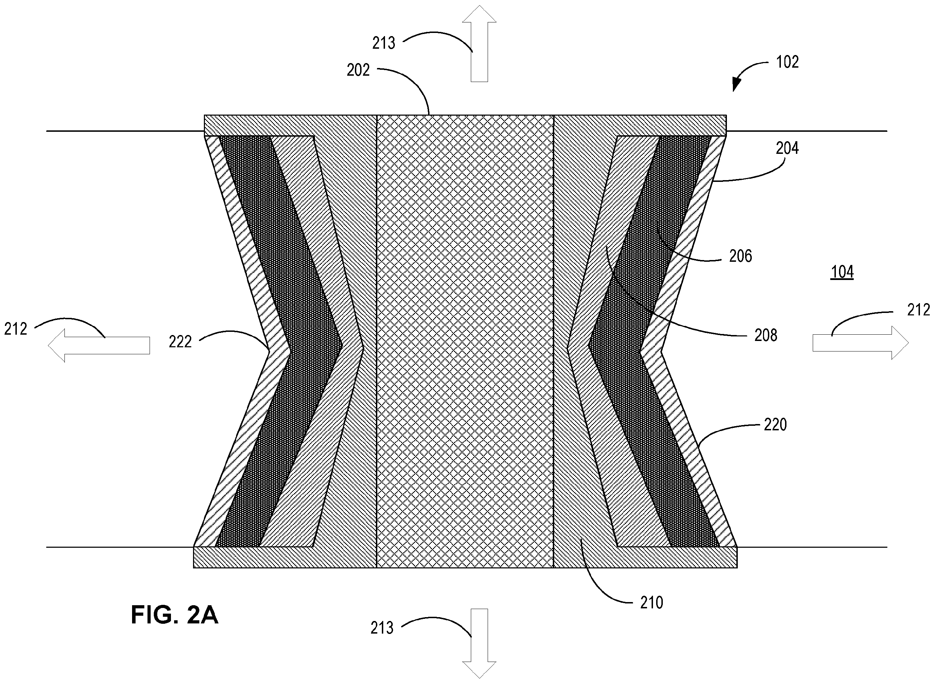

In operation, the example inductors 102 that are positioned in the glass substrate 104 are electrically coupled to the interconnects 112 such that the interconnects 112 supply the inductors 102 with current. In particular, as will be discussed in greater detail below in connection with FIGS. 2A-8, an arrangement of layers (e.g., diametric layers, lateral layers, etc.), including ferrous layers surrounding a core (e.g., a central core) within glass (e.g., the glass substrate 104) enables a greater degree of control over inductive properties and/or capabilities. As a result, examples disclosed herein can have a relatively high conversion efficiency, as well as an increased quality factor.

According to some examples disclosed herein, a dielectric (e.g., a dielectric material) is utilized in conjunction with a ferrous film/layer. Additionally or alternatively, multiple ferrous films/layers are utilized such that the ferrite films/layers are arranged diametrically (e.g., in cylindrical shaped structures) from a core or central conductor of the inductor 102, for example. In other words, the ferrous films/layers can be laterally arranged from one another. While ferrous films/layers are described in conjunction with examples disclosed herein, any appropriate metal or other material having magnetic properties and/or behavior can be implemented instead. In some examples, alternating lateral layers of dielectrics and magnetic alloys (e.g., magnetic metal alloys) are utilized.

FIG. 2A is a detailed cross-sectional view of the example inductor 102 in accordance with teachings of this disclosure. As can be seen in the illustrated example of FIG. 2A, the example inductor 102 is shown embedded and/or placed within the glass substrate 104. The example inductor 102 includes a metal core (e.g., a central core, a seed layer) 202, which includes copper in this example, a seed layer (e.g., a metal seed layer) 204, a ferrite layer (e.g., a ferrite film) 206, and a magnetic alloy layer 208 that is adjacent and coupled to a dielectric (e.g., a dielectric structure) 210. In the illustrated example of FIG. 2A, the magnetic alloy layer 208 contacts and laterally surrounds the aforementioned core 202. In some examples, the ferrite layer 206 is not implemented. As used herein (and throughout the present disclosure), a lateral direction is a direction (represented by arrows 212 in FIG. 2A) that extends generally parallel to a plane of the glass substrate 104 and transverse to a central axis of the inductor arrows 212 extending through the glass substrate 104. By contrast, as used herein, a longitudinal direction is a direction (represented by arrows 213 in FIG. 2A) that extends generally parallel to the central axis of the inductor arrows 212 and transverse to the plane of the glass substrate 104. Additionally or alternatively, the core 202 may be defined and/or produced as a metal seed layer, for example. In some examples, the ferrite layer 206 has a thickness of approximately 1-10 microns.

The example magnetic alloy layer 208 can include any appropriate magnetic composition and/or material, such as, but not limited to, Permalloy^{™}, which can include iron and nickel, a MuMetal^{®} alloy, which can include a nickel-iron ferromagnetic alloy, or a Nanoperm^{®} alloy, which can include an iron-based alloy with a relatively fine crystalline structure. The aforementioned magnetic alloy materials can have a relatively high relative permeability range (e.g., permeability ranges of approximately 5,000 to 100,000, permeabilities between 8,000 and 80,000, etc.). However, any other appropriate magnetic composition and/or material can be implemented instead.

The ferrite layer 206 (or any of the other example ferrite layers disclosed herein) can include a nickel zinc ferrite (e.g., NiₐZn₍₁₋ₐ₎Fe2O₄), a manganese ferrite (e.g., MnₐZn₍₁₋ₐ₎Fe₂O₄ or a cobalt ferrite (e.g., CoFe₂O₄, CoO Fe₂O₃). However, any other type of material can be implemented instead.According to examples disclosed herein, the core 202 is electrically coupled to the interconnects 112 (shown in FIG. 1). Implementing at least one of the ferrite layer 206 or the magnetic alloy layer 208 enables improved inductive functionality as current passes through the core 202. As a result, examples disclosed can enable effective inductive operation in combination with the RF signal advantages of utilizing glass core technology in semiconductor/IC packages.

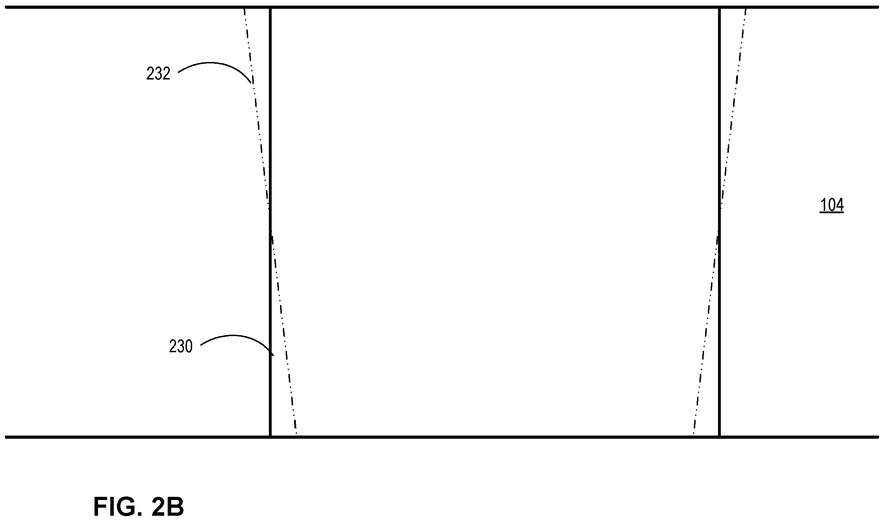

In this example, drilling of the glass substrate 104 causes the seed layer 204 and/or the inductor 102 to have a generally converging and/or ramped overall shape 220 (e.g., a shape having a geometry resembling an hourglass) such that a portion 222 of the inductor 102 with the smallest width (in the view of FIG. 2A) is within a depth of the glass substrate 104. However, any appropriate shape of an aperture in the glass substrate 104 can be implemented instead. For example, an aperture surrounding the inductor 102 can, instead, have relatively straight walls (e.g., walls not exhibiting any taper) extending through a thickness of the glass substrate 104, as described below in connection with FIG. 2B.

FIG. 2B depicts alternative example aperture shapes in which examples disclosed herein can be implemented. In this example, an aperture 230 represents aperture walls that are relatively parallel and/or substantially perpendicular to the outer/planar surfaces of the glass substrate 104. Alternatively, an aperture 232 represents a tapered or angled aperture that longitudinally extends along a depth of the glass substrate 104. The inductor 102 of FIG. 2A (or any of the example inductors described herein) can be implemented in apertures shaped similar to the aperture 230 or the aperture 232, for example.

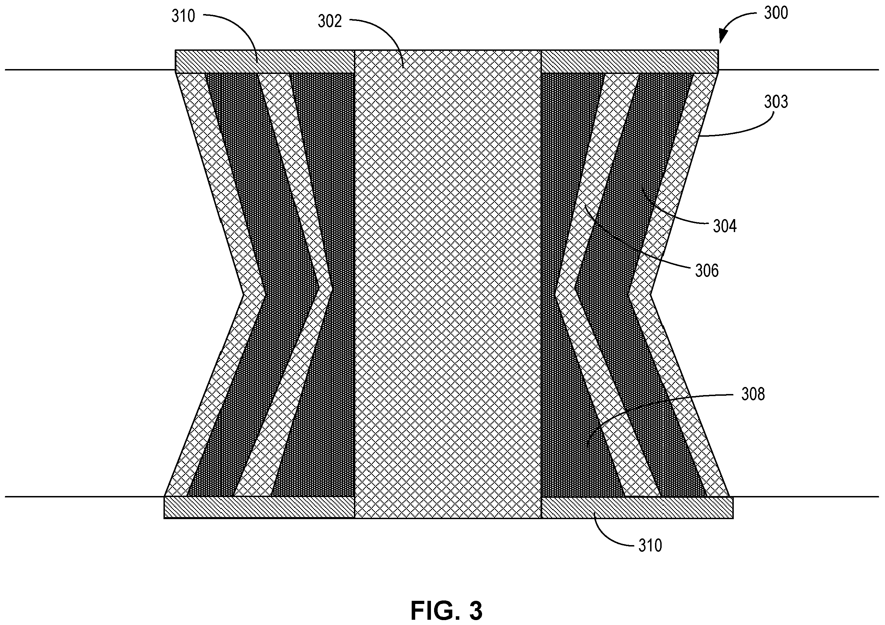

FIG. 3 is a detailed cross-sectional view of another example inductor 300 in accordance with teachings of this disclosure. The inductor 300 of the illustrated example is similar to the example inductor 102 of FIG. 2A but, instead, includes an example arrangement with multiple ferrite layers. The example inductor includes a core 302, a seed layer 303, a first ferrite layer (e.g., a ferrite film) 304, a second seed layer 306, and a second ferrite layer (e.g., a ferrite film) 308 that is adjacent and contacts the aforementioned core 302. In this example, the first ferrite layer 304 and the second ferrite layer 308 have a generally similar or identical material composition (e.g., the same ferrite materials having compositions within 1-5% of one another). In other examples, the first ferrite layer 304 and the second ferrite layer 308 do not have similar or identical materials and/or composition.

According to examples disclosed herein, a dielectric layer (e.g., a dielectric cap layer, a dielectric end, a dielectric end layer, a dielectric covering, etc.) 310 having insulating material (e.g., silicon, silicon dioxide, silicon nitride, etc.) can be implemented at or proximate longitudinal ends of the inductor 300. In the illustrated example of FIG. 3, the dielectric layer 310 is at longitudinal ends of the seed layer 303, the first ferrite layer 304, the second seed layer 306, and the second ferrite layer 308. However, the dielectric layer 310 can be adjacent and/or coupled to any combination of the seed layer 303, the first ferrite layer 304, the second seed layer 306, and the second ferrite layer 308. In some examples, multiple ones of the ferrite layers and/or other layers (e.g., dielectric layers, seed layers, etc.) are implemented until a desired thickness is reached.

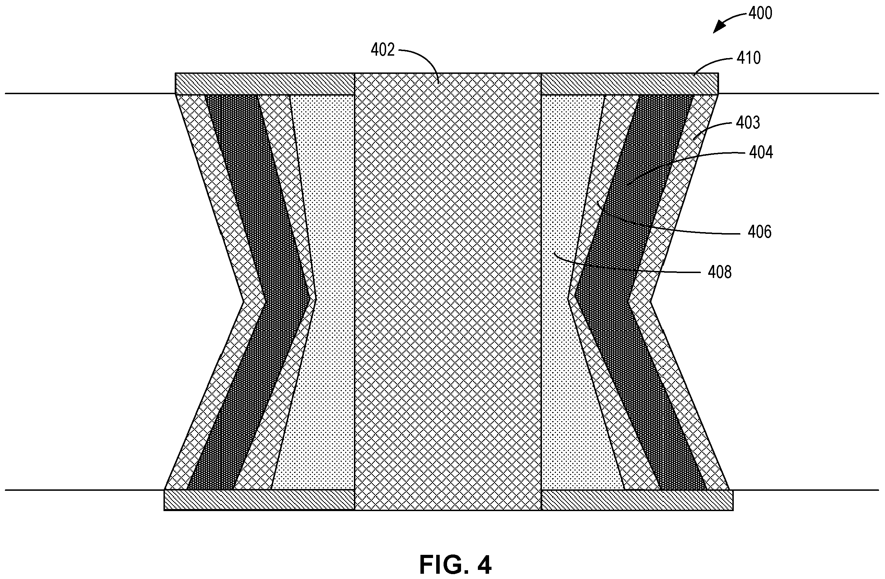

FIG. 4 is a detailed cross-sectional view of yet another example inductor 400 in accordance with teachings of this disclosure. The inductor 400 of the illustrated example is similar to the example multi-layered ferrite-based inductor 300 of FIG. 3 but, instead, includes a multiple ferrite layer arrangement with different ferrite layers such that the different ferrite layers have a different composition (e.g., different relative compositions of metals and/or metal oxides, etc.) and/or consist of different materials (e.g., different ferrite materials and/or metal oxides) from one another. The example inductor 400 includes a core 402, a seed layer 403, a first ferrite layer (e.g., a first ferrite film) 404, a second seed layer 406, and a second ferrite layer (e.g., a second ferrite film) 408 that is adjacent and contacts the aforementioned core 402. In this example, the first ferrite layer 404 and the second ferrite layer 408 are of different composition and/or materials (e.g., different ferrite materials). Additionally or alternatively, the first ferrite layer 404 and the second ferrite layer 408 have different permeability, loss, and/or magnetic saturation properties, etc.

In some examples, a dielectric base 410 is implemented to cover longitudinal ends of the seed layer 403, the first ferrite layer 404, the second seed layer 406, and/or the second ferrite layer 408. Additionally or alternatively, a dielectric layer is positioned between the second ferrite layer 408 and the core 402.

The example inductors 102, 300, 400 of FIGS. 2A-4 are examples and any of the features and/or aspects thereof can be combined with any other of the example inductors 102, 300, 400. In other words, utilization of layers, arrangements, numbers of layers, magnetic layering structure and/or architectures, etc. can be combined between the different examples disclosed herein for different applications and/or to customize different performance parameters (e.g., efficiency, loss, permeability, frequency performance range, etc.).

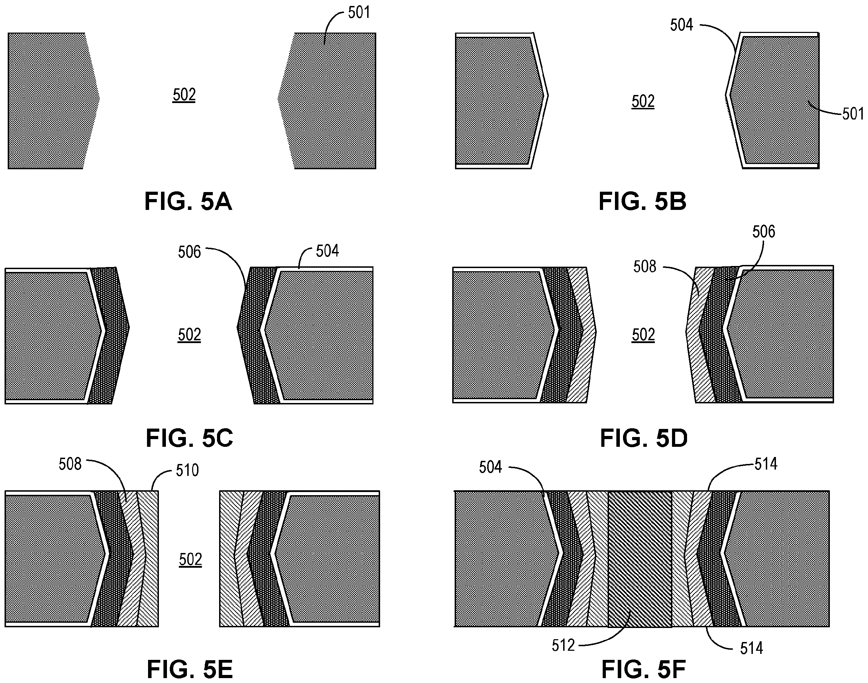

FIGS. 5A-5F are cross-sectional views illustrating an example method to produce examples disclosed herein. In particular, a glass-integrated inductor (e.g., the inductor 102) is to be produced with a magnetic alloy dielectric architecture. Turning to FIG. 5A, a glass substrate 501 exhibiting a generally planar shape is drilled to define an aperture 502 therein. In this example, the aperture 502 is a through-hole that extends through an entire thickness of the glass substrate 501.

FIG. 5B depicts a seed layer (e.g., a metal seed layer) 504 applied to and/or deposited onto the glass substrate 501. In this example, the metal seed layer 504 is at least partially composed of copper and provided via an electroless deposition process. As can be seen in the illustrated example of FIG. 5B, the seed layer 504 covers multiple surfaces and/or edges of the glass substrate 501, including inner surfaces (e.g., an inner face) of the aperture 502.

Turning to FIG. 5C, in some examples, a ferrite film 506 is applied, deposited and/or provided to be adjacent the seed layer 504 and within the aperture 502. The example ferrite film 506 can be applied via an electro-plating annealing process or a spin-spray deposition process, for example. According to examples disclosed herein, the ferrite film 506 can be applied by an electroplating annealing process that involves electroplating selected/desired metals followed by annealing a metal alloy at a temperature exceeding 400 degrees Celsius (°C). Glass cores/substrates advantageously enable this annealing step at a relatively high temperature. In some examples, the ferrite film 506 includes at least one of nickel or zinc.

According to examples disclosed herein, FIG. 5D depicts a deposition of a magnetic/metal alloy layer 508 into/onto the aperture 502. The magnetic/metal alloy 508 can be provided to cover at least a portion of the ferrite film 506 via an electroless deposition process followed by an electroless or an electroplating deposition process, for example. The example magnetic/metal alloy layer 508 can be utilized alternatively or additionally to other ferrite films utilized. Additionally or alternatively, a seed layer (e.g., a copper seed layer) is provided to the ferrite film 506.

FIG. 5E depicts a deposition of a dielectric 510. The second dielectric 510 can be applied and/or deposited to cover at least a portion of the magnetic/metal alloy layer 508. In some examples, the aperture 502 is at least partially open (e.g., not fully filled) subsequent to deposition of the dielectric 510. Additionally or alternatively to deposition of the dielectric 510, a second ferrite film is applied.

FIG. 5F depicts deposition of copper to define a core 512. The core 512 can be produced by an electroless deposition followed by an electroless or electroplating deposition process, for example. The example core 512 may be produced as a seed layer via a plating process. Further, remaining material including portions of metal from the first seed layer 504 are removed (e.g., etched, polished, etc.), thereby defining exposed surfaces 514. In some examples, a dielectric cap is added to cover longitudinal ends of lateral layers.

The example process shown in FIGS. 5A-5F is only an example and any steps and/or aspects can be omitted and/or varied based on parameters of the inductor being produced. In a specific example, the produced inductor may include alternating magnetic alloy layers in combination with at least one dielectric layer in lieu of including a single ferrite layer/film. In some examples, different types of inductors and/or different layering arrangements are utilized in the same glass substrate/core.

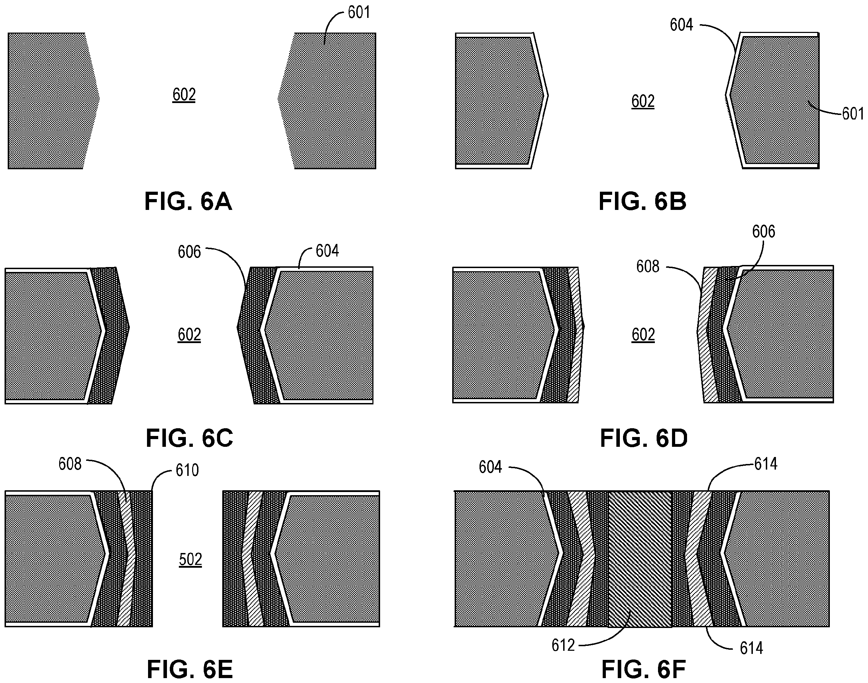

FIGS. 6A-6F are cross-sectional views illustrating an example method to produce examples disclosed herein. In particular, a glass-integrated inductor (the inductor 300, the inductor 400) is to be produced with alternating ferrite-metal layers. The aforementioned example ferrite layers can be of the same composition or different composition to one another. Turning to FIG. 5A, a glass substrate 601 is drilled to define an aperture 602 therein. In this example, the aperture 502 is a through-hole that extends through an entire thickness of the glass substrate 601.

FIG. 6B depicts a seed layer (e.g., a metal seed layer, a copper seed layer) 604 applied to and/or deposited onto the glass substrate 601. In this example, the metal seed layer 604 is at least partially composed of copper and provided via an electroless deposition process. As can be seen in the illustrated example of FIG. 6B, the seed layer 604 covers multiple surfaces and/or edges of the glass substrate 601, including inner surfaces of the aperture 602.

Turning to FIG. 6C, a first ferrite film 606 is applied, deposited and/or provided to be adjacent the seed layer 604 and within the aperture 602. The example first ferrite film 606 can be applied via an electro-plating annealing process or a spin-spray deposition process, for example. According to particular examples disclosed herein, the first ferrite film 606 can be applied by an electro-plating annealing process that involves electroplating selected/desired metals followed by annealing a metal alloy at a temperature exceeding 400 degrees Celsius (°C).

FIG. 6D depicts a deposition of a second seed layer 608 into the aperture 602. The second seed layer 608 can be provided to cover at least a portion of the first ferrite film 606 via an electroless deposition process followed by an electroless or an electroplating deposition process, for example. Additionally or alternatively, a seed layer (e.g., a copper seed layer) is provided to the first ferrite film 606.

FIG. 6E depicts a deposition of a second ferrite film 610. The second ferrite film 610 can be applied to cover at least a portion of the magnetic/metal alloy layer 608 via an electroplating annealing process or a spin-spray deposition process. In some examples, the aperture 602 is at least partially open (e.g., unfilled) subsequent to deposition of the second ferrite film 610. Additionally or alternatively, a dielectric (e.g., a dielectric layer) is applied to the magnetic/metal alloy layer 608.

FIG. 6F depicts deposition of copper to define a core (e.g., a metal core) 612. The core 612 can be produced by an electroless deposition followed by an electroless or electroplating deposition process, for example. The example core 612 may be produced as a seed layer. Further, remaining material including metal from the first seed layer 604 is removed (e.g., etched, polished, etc.), thereby defining exposed surfaces 614. In some examples, a dielectric cap is added to cover longitudinal ends of lateral layers.

The example process shown in FIGS. 6A-6F is only an example and any steps and/or aspects can be omitted and/or varied based on parameters of the inductor being produced. In some examples, different types of inductors and/or different layering arrangements are utilized in the same glass substrate/core.

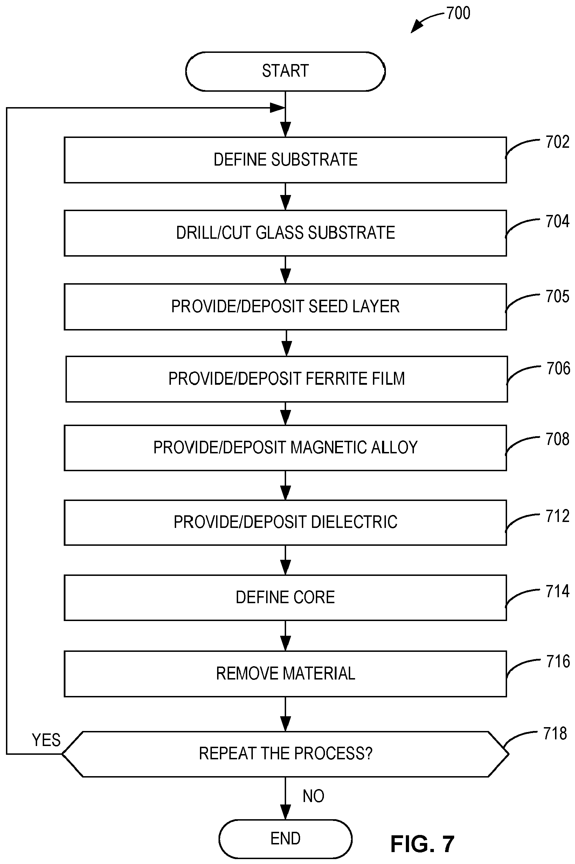

FIG. 7 is flowchart representative of an example method 700 to produce examples disclosed herein. The example method 700 is implemented to produce at least one glass-integrated inductor (e.g., the inductor 102).

At block 702, the glass substrate is defined and/or produced. In this example, the glass substrate is a generally planar shaped layer.

At block 704, the glass substrate is drilled/cut to define an aperture extending therethrough. Any appropriate drilling, etching and/or cutting process can be utilized.

At block 705, a seed layer is provided and/or deposited onto the glass substrate. In this example, the seed layer covers at least a portion of the aperture.

At block 706, in some examples, a ferrite film is provided and/or deposited onto the aperture of the glass substrate. The ferrite film can be applied as a lateral layer via an electro-plating annealing process, spin-spray coating or any other appropriate process.

At block 708, in some examples, a magnetic metal alloy is provided and/or deposited onto the aperture of the glass substrate. The magnetic metal alloy can be applied as a lateral layer via electroless/electroplating process or any other appropriate process.

At block 712, in some examples, a dielectric (e.g., a dielectric layer) is provided and/or deposited into the aperture. As a result, the dielectric can prevent leaching of the inductor, for example.

At block 714, a conductive core (e.g., a central conductive core, a copper core, a metal core, etc.) is defined, provided and/or deposited. In this example, the core is centrally positioned in the aperture and is at least partially composed of copper. According to examples disclosed herein, the core can be produced and/or defined via a seed layer and/or seed layer deposition process. In this example, the core is at least partially composed of copper.

At block 716, material including at least a portion of the seed layer is removed (e.g., etched, polished, etc.). In some examples, the metal of the seed layer is removed via a laser or by chemical-mechanical polishing. However, any other appropriate step to remove and/or reduce metal can be implemented instead.

At block 718, it is determined whether to repeat the process. If the process is to be repeated (block 718), control of the process returns to block 702. Otherwise, the process ends. This determination may be based on whether additional inductors and/or glass substrates with integrated inductors are to be defined.

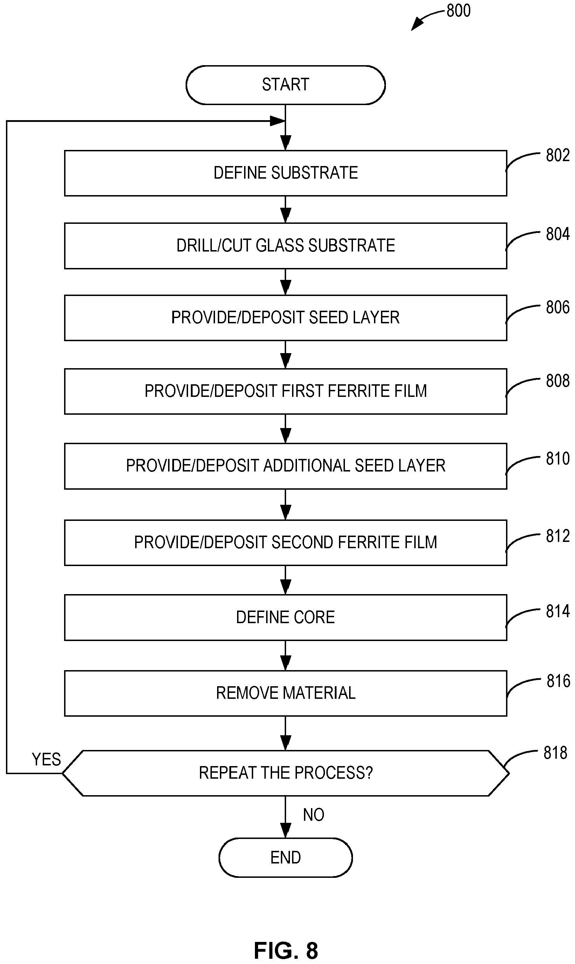

FIG. 8 is flowchart representative of an example method 800 to produce examples disclosed herein. The example method 800 is implemented to produce at least one glass-integrated inductor (e.g., the inductor 300, the inductor 400) having multiple ferrite layers.

At block 802, the glass substrate is defined and/or produced.

At block 804, the glass substrate is drilled/cut to define an aperture extending therethrough.

At block 806, a seed layer including copper is provided and/or deposited onto the glass substrate. In this example, the seed layer covers at least a portion of the aperture.

At block 808, according to examples disclosed herein, a first ferrite film is provided and/or deposited onto the aperture of the glass substrate. The first ferrite film can be applied as a lateral layer via an electro-plating annealing process, spin-spray coating process or any other appropriate process.

At block 810, in some examples, an additional seed layer is provided and/or deposited. As a result, the additional seed layer covers and/or contacts at least a portion of the aforementioned ferrite film.

At block 812, in some examples, a second ferrite film is provided and/or deposited. In this example, the additional seed layer is layered between the first and second ferrite films.

At block 814, a conductive core (e.g., a central conductive core, a copper core, etc.) is defined, provided and/or deposited. In this example, the core is centrally positioned in the aperture and is at least partially composed of copper. According to examples disclosed herein, the core can be produced and/or defined via a seed layer and/or seed layer deposition process.

At block 816, material including metal of at least one of the seed layers is removed (e.g., etched, polished, etc.). In some examples, the metal of at least of the seed layers is removed via a laser or by chemical-mechanical polishing. However, any other appropriate step to remove and/or reduce the material can be implemented instead.

At block 818, it is determined whether to repeat the process. If the process is to be repeated (block 818), control of the process returns to block 802. Otherwise, the process ends. This determination may be based on whether additional inductors and/or glass substrates with integrated inductors are to be defined.

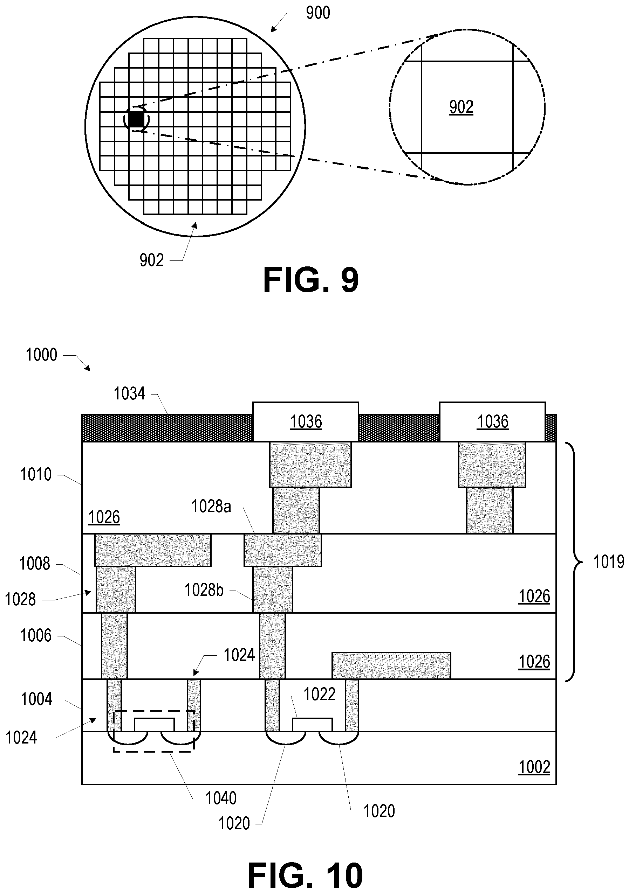

The example glass-integrated inductors disclosed herein may be included in any suitable electronic component. FIGS. 9-13 illustrate various examples of apparatus that may include and/or be associated with the example inductors disclosed herein.

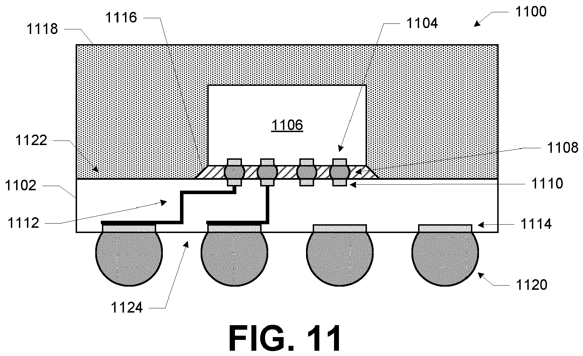

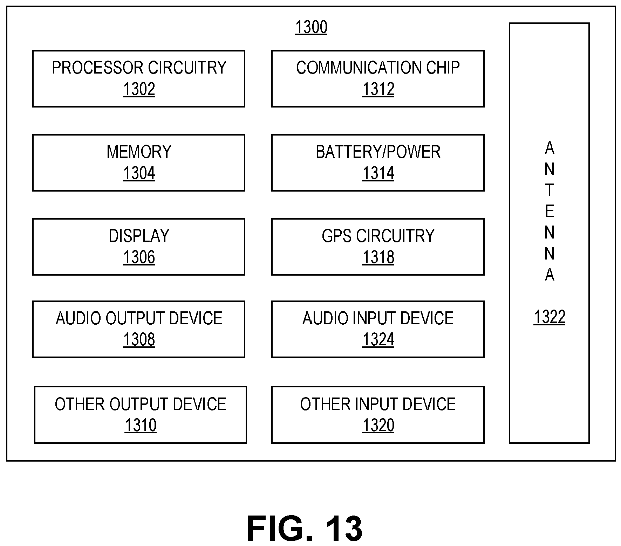

FIG. 9 is a top view of a wafer 900 and dies 902 that may be included in an IC package whose substrate includes one or more glass-integrated inductors (e.g., as discussed below with reference to FIG. 11) in accordance with any of the examples disclosed herein. The wafer 900 may be composed of semiconductor material and may include one or more dies 902 having circuitry. Each of the dies 902 may be a repeating unit of a semiconductor product. After the fabrication of the semiconductor product is complete, the wafer 900 may undergo a singulation process in which the dies 902 are separated from one another to provide discrete "chips." The die 902 may include one or more transistors (e.g., some of the transistors 1040 of FIG. 10, discussed below), supporting circuitry to route electrical signals to the transistors, passive components (e.g., traces, resistors, capacitors, inductors, and/or other circuitry), and/or any other components. In some examples, the die 902 may include and/or implement a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuitry. Multiple ones of these devices may be combined on a single die 902. For example, a memory array formed by multiple memory circuits may be formed on a same die 902 as programmable circuitry (e.g., the processor circuitry 1302 of FIG. 13) or other logic circuitry. Such memory may store information or instructions for use by the programmable circuitry. The example glass-integrated inductors disclosed herein may be manufactured using a die-to-wafer assembly technique in which some dies are attached to a wafer 900 that include others of the dies, and the wafer 900 is subsequently singulated.

FIG. 10 is a cross-sectional side view of an IC device 1000 that may be included in an IC package whose substrate includes one or more glass-integrated inductors (e.g., as discussed below with reference to FIG. 11), in accordance with any of the examples disclosed herein. One or more of the IC devices 1000 may be included in one or more dies 902 (FIG. 9). The IC device 1000 may be formed on a die substrate 1002 (e.g., the wafer 900 of FIG. 9) and may be included in a die (e.g., the die 902 of FIG. 9). The die substrate 1002 may be a semiconductor substrate composed of semiconductor material systems including, for example, n-type or p-type materials systems (or a combination of both). The die substrate 1002 may include, for example, a crystalline substrate formed using a bulk silicon or a silicon-on-insulator (SOI) substructure. In some examples, the die substrate 1002 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the die substrate 1002. Although a few examples of materials from which the die substrate 1002 may be formed are described here, any material that may serve as a foundation for an IC device 1000 may be used. The die substrate 1002 may be part of a singulated die (e.g., the dies 902 of FIG. 9) or a wafer (e.g., the wafer 900 of FIG. 9).

The IC device 1000 may include one or more device layers 1004 disposed on or above the die substrate 1002. The device layer 1004 may include features of one or more transistors 1040 (e.g., metal oxide semiconductor field-effect transistors (MOSFETs)) formed on the die substrate 1002. The device layer 1004 may include, for example, one or more source and/or drain (S/D) regions 1020, a gate 1022 to control current flow between the S/D regions 1020, and one or more S/D contacts 1024 to route electrical signals to/from the S/D regions 1020. The transistors 1040 may include additional features not depicted for the sake of clarity, such as device isolation regions, gate contacts, and the like. The transistors 1040 are not limited to the type and configuration depicted in FIG. 10 and may include a wide variety of other types and/or configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1040 may include a gate 1022 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 1040 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some examples, when viewed as a cross-section of the transistor 1040 along the source-channel-drain direction, the gate electrode may consist of a U-shaped structure that includes a bottom portion substantially parallel to the surface of the die substrate 1002 and two sidewall portions that are substantially perpendicular to the top surface of the die substrate 1002. In other examples, at least one of the metal layers that form the gate electrode may simply be a planar layer that is substantially parallel to the top surface of the die substrate 1002 and does not include sidewall portions substantially perpendicular to the top surface of the die substrate 1002. In other examples, the gate electrode may consist of a combination of U-shaped structures and planar, non-U-shaped structures. For example, the gate electrode may consist of one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some examples, a plurality of spacer pairs may be used; for instance, two pairs, three pairs, or four pairs of sidewall spacers may be formed on opposing sides of the gate stack.

The S/D regions 1020 may be formed within the die substrate 1002 adjacent to the gate 1022 of each transistor 1040. The S/D regions 1020 may be formed using an implantation/diffusion process or an etching/deposition process, for example. In the former process, dopants such as boron, aluminum, antimony, phosphorous, or arsenic may be ion-implanted into the die substrate 1002 to form the S/D regions 1020. An annealing process that activates the dopants and causes them to diffuse farther into the die substrate 1002 may follow the ion-implantation process. In the latter process, the die substrate 1002 may first be etched to form recesses at the locations of the S/D regions 1020. An epitaxial deposition process may then be carried out to fill the recesses with material that is used to fabricate the S/D regions 1020. In some implementations, the S/D regions 1020 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 1020 may be formed using one or more alternate semiconductor materials such as germanium or a group III-V material or alloy. In further examples, one or more layers of metal and/or metal alloys may be used to form the S/D regions 1020.

Electrical signals, such as power and/or input/output (I/O) signals, may be routed to and/or from the devices (e.g., transistors 1040) of the device layer 1004 through one or more interconnect layers disposed on the device layer 1004 (illustrated in FIG. 10 as interconnect layers 1006-1010). For example, electrically conductive features of the device layer 1004 (e.g., the gate 1022 and the S/D contacts 1024) may be electrically coupled with the interconnect structures 1028 of the interconnect layers 1006-1010. The one or more interconnect layers 1006-1010 may form a metallization stack (also referred to as an "ILD stack") 1019 of the IC device 1000.

The interconnect structures 1028 may be arranged within the interconnect layers 1006-1010 to route electrical signals according to a wide variety of designs (in particular, the arrangement is not limited to the particular configuration of interconnect structures 1028 depicted in FIG. 10). Although a particular number of interconnect layers 1006-1010 is depicted in FIG. 10, examples of the present disclosure include IC devices having more or fewer interconnect layers than depicted.

In some examples, the interconnect structures 1028 may include lines 1028a and/or vias 1028b filled with an electrically conductive material such as a metal. The lines 1028a may be arranged to route electrical signals in a direction of a plane that is substantially parallel with a surface of the die substrate 1002 upon which the device layer 1004 is formed. For example, the lines 1028a may route electrical signals in a direction in and out of the page from the perspective of FIG. 10. The vias 1028b may be arranged to route electrical signals in a direction of a plane that is substantially perpendicular to the surface of the die substrate 1002 upon which the device layer 1004 is formed. In some examples, the vias 1028b may electrically couple lines 1028a of different interconnect layers 1006-1010 together.

The interconnect layers 1006-1010 may include a dielectric material 1026 disposed between the interconnect structures 1028, as shown in FIG. 10. In some examples, the dielectric material 1026 disposed between the interconnect structures 1028 in different ones of the interconnect layers 1006-1010 may have different compositions; in other examples, the composition of the dielectric material 1026 between different interconnect layers 1006-1010 may be the same.

A first interconnect layer 1006 (referred to as Metal 1 or "M1") may be formed directly on the device layer 1004. In some examples, the first interconnect layer 1006 may include lines 1028a and/or vias 1028b, as shown. The lines 1028a of the first interconnect layer 1006 may be coupled with contacts (e.g., the S/D contacts 1024) of the device layer 1004.

A second interconnect layer 1008 (referred to as Metal 2 or "M2") may be formed directly on the first interconnect layer 1006. In some examples, the second interconnect layer 1008 may include vias 1028b to couple the lines 1028a of the second interconnect layer 1008 with the lines 1028a of the first interconnect layer 1006. Although the lines 1028a and the vias 1028b are structurally delineated with a line within each interconnect layer (e.g., within the second interconnect layer 1008) for the sake of clarity, the lines 1028a and the vias 1028b may be structurally and/or materially contiguous (e.g., simultaneously filled during a dual-damascene process) in some examples.

A third interconnect layer 1010 (referred to as Metal 3 or "M3") (and additional interconnect layers, as desired) may be formed in succession on the second interconnect layer 1008 according to similar techniques and configurations described in connection with the second interconnect layer 1008 or the first interconnect layer 1006. In some examples, the interconnect layers that are "higher up" in the metallization stack 1019 in the IC device 1000 (i.e., further away from the device layer 1004) may be thicker.

The IC device 1000 may include a solder resist material 1034 (e.g., polyimide or similar material) and one or more conductive contacts 1036 formed on the interconnect layers 1006-1010. In FIG. 10, the conductive contacts 1036 are illustrated as taking the form of bond pads. The conductive contacts 1036 may be electrically coupled with the interconnect structures 1028 and configured to route the electrical signals of the transistor(s) 1040 to other external devices. For example, solder bonds may be formed on the one or more conductive contacts 1036 to mechanically and/or electrically couple a chip including the IC device 1000 with another component (e.g., a circuit board). The IC device 1000 may include additional or alternate structures to route the electrical signals from the interconnect layers 1006-1010; for example, the conductive contacts 1036 may include other analogous features (e.g., posts) that route the electrical signals to external components.

FIG. 11 is a cross-sectional view of an example IC package 1100 that may include one or more glass-integrated inductors. The package substrate 1102 may be formed of a dielectric material, and may have conductive pathways extending through the dielectric material between upper and lower faces 1122, 1124, or between different locations on the upper face 1122, and/or between different locations on the lower face 1124. These conductive pathways may take the form of any of the interconnects 1028 discussed above with reference to FIG. 10. In some examples, any number of glass-integrated inductors (with any suitable structure) may be included in a package substrate 1102. In some examples, no glass-integrated inductors may be included in the package substrate 1102.

The IC package 1100 may include a die 1106 coupled to the package substrate 1102 via conductive contacts 1104 of the die 1106, first-level interconnects 1108, and conductive contacts 1110 of the package substrate 1102. The conductive contacts 1110 may be coupled to conductive pathways 1112 through the package substrate 1102, allowing circuitry within the die 1106 to electrically couple to various ones of the conductive contacts 1114 or to the glass-integrated inductor (or to other devices included in the package substrate 1102, not shown). The first-level interconnects 1108 illustrated in FIG. 11 are solder bumps, but any suitable first-level interconnects 1108 may be used. As used herein, a "conductive contact" refers to a portion of conductive material (e.g., metal) serving as an electrical interface between different components. Conductive contacts may be recessed in, flush with, or extending away from a surface of a component, and may take any suitable form (e.g., a conductive pad or socket).

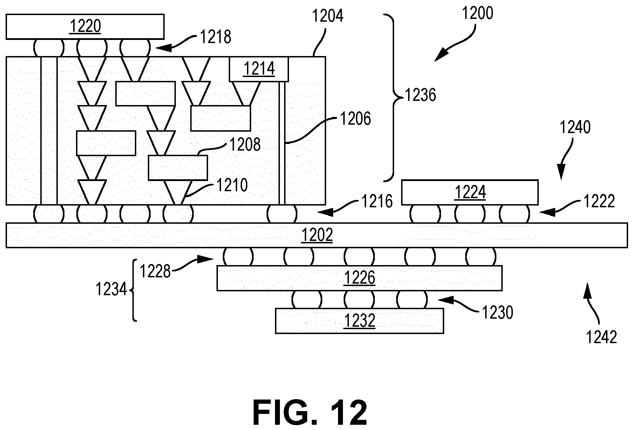

In some examples, an underfill material 1116 may be disposed between the die 1106 and the package substrate 1102 around the first-level interconnects 1108, and a mold compound 1118 may be disposed around the die 1106 and in contact with the package substrate 1102. In some examples, the underfill material 1116 may be the same as the mold compound 1118. Example materials that may be used for the underfill material 1116 and the mold compound 1118 are epoxy mold materials, as suitable. Second-level interconnects 1120 may be coupled to the conductive contacts 1114. The second-level interconnects 1120 illustrated in FIG. 11 are solder balls (e.g., for a ball grid array arrangement), but any suitable second-level interconnects 1120 may be used (e.g., pins in a pin grid array arrangement or lands in a land grid array arrangement). The second-level interconnects 1120 may be used to couple the IC package 1100 to another component, such as a circuit board (e.g., a motherboard), an interposer, or another IC package, as known in the art and as discussed below with reference to FIG. 12.

In FIG. 11, the IC package 1100 is a flip chip package, and includes a glass-integrated inductor in the package substrate 1102. The number and location of glass-integrated inductor in the package substrate 1102 of the IC package 1100 is simply illustrative, and any number of glass-integrated inductors (with any suitable structure) may be included in a package substrate 1102. In some examples, no glass-integrated inductor may be included in the package substrate 1102. The die 1106 may take the form of any of the examples of the die 1302 discussed herein (e.g., may include any of the examples of the IC device 1000). In some examples, the die 1106 may include one or more glass-integrated inductors (e.g., as discussed above with reference to FIG. 9 and FIG. 10); in other examples, the die 1106 may not include any glass-integrated inductors.

Although the IC package 1100 illustrated in FIG. 11 is a flip chip package, other package architectures may be used. For example, the IC package 1100 may be a ball grid array (BGA) package, such as an embedded wafer-level ball grid array (eWLB) package. In another example, the IC package 1100 may be a wafer-level chip scale package (WLCSP) or a panel fanout (FO) package. Although a single die 1106 is illustrated in the IC package 1100 of FIG. 11, an IC package 1100 may include multiple dies 1106 (e.g., with one or more of the multiple dies 1106 coupled to glass-integrated inductors included in the package substrate 1102). An IC package 1100 may include additional passive components, such as surface-mount resistors, capacitors, and inductors disposed on the first face 1122 or the second face 1124 of the package substrate 1102. More generally, an IC package 1100 may include any other active or passive components known in the art.

FIG. 12 is a cross-sectional side view of an IC device assembly 1200 that may include the glass-integrated inductors disclosed herein. In some examples, the IC device assembly corresponds to the glass-integrated inductors. The IC device assembly 1200 includes a number of components disposed on a circuit board 1202 (which may be, for example, a motherboard). The IC device assembly 1200 includes components disposed on a first face 1240 of the circuit board 1202 and an opposing second face 1242 of the circuit board 1202; generally, components may be disposed on one or both faces 1240 and 1242.

In some examples, the circuit board 1202 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1202. In other examples, the circuit board 1202 may be a non-PCB substrate.

The IC device assembly 1200 illustrated in FIG. 12 includes a package-on-interposer structure 1236 coupled to the first face 1240 of the circuit board 1202 by coupling components 1216. The coupling components 1216 may electrically and mechanically couple the package-on-interposer structure 1236 to the circuit board 1202, and may include solder balls (as shown in FIG. 12), male and female portions of a socket, an adhesive, an underfill material, and/or any other suitable electrical and/or mechanical coupling structure.

The package-on-interposer structure 1236 may include an IC package 1220 coupled to an interposer 1204 by coupling components 1218. The coupling components 1218 may take any suitable form for the application, such as the forms discussed above with reference to the coupling components 1216. Although a single IC package 1220 is shown in FIG. 12, multiple IC packages may be coupled to the interposer 1204; indeed, additional interposers may be coupled to the interposer 1204. The interposer 1204 may provide an intervening substrate used to bridge the circuit board 1202 and the IC package 1220. The IC package 1220 may be or include, for example, a die (the die 902 of FIG. 9), an IC device (e.g., the IC device 1000 of FIG. 10), or any other suitable component. Generally, the interposer 1204 may spread a connection to a wider pitch or reroute a connection to a different connection. For example, the interposer 1204 may couple the IC package 1220 (e.g., a die) to a set of BGA conductive contacts of the coupling components 1216 for coupling to the circuit board 1202. In the example illustrated in FIG. 12, the IC package 1220 and the circuit board 1202 are attached to opposing sides of the interposer 1204; in other examples, the IC package 1220 and the circuit board 1202 may be attached to a same side of the interposer 1204. In some examples, three or more components may be interconnected by way of the interposer 1204.

In some examples, the interposer 1204 may be formed as a PCB, including multiple metal layers separated from one another by layers of dielectric material and interconnected by electrically conductive vias. In some examples, the interposer 1204 may be formed of an epoxy resin, a fiberglass-reinforced epoxy resin, an epoxy resin with inorganic fillers, a ceramic material, or a polymer material such as polyimide. In some examples, the interposer 1204 may be formed of alternate rigid or flexible materials that may include the same materials described above for use in a semiconductor substrate, such as silicon, germanium, and other group III-V and group IV materials. The interposer 1204 may include metal interconnects 1208 and vias 1210, including but not limited to through-silicon vias (TSVs) 1206. The interposer 1204 may further include embedded devices 1214, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1204. The package-on-interposer structure 1236 may take the form of any of the package-on-interposer structures known in the art.

The IC device assembly 1200 may include an IC package 1224 coupled to the first face 1240 of the circuit board 1202 by coupling components 1222. The coupling components 1222 may take the form of any of the examples discussed above with reference to the coupling components 1216, and the IC package 1224 may take the form of any of the examples discussed above with reference to the IC package 1220.

The IC device assembly 1200 illustrated in FIG. 12 includes a package-on-package structure 1234 coupled to the second face 1242 of the circuit board 1202 by coupling components 1228. The package-on-package structure 1234 may include a first IC package 1226 and a second IC package 1232 coupled together by coupling components 1230 such that the first IC package 1226 is disposed between the circuit board 1202 and the second IC package 1232. The coupling components 1228, 1230 may take the form of any of the examples of the coupling components 1216 discussed above, and the IC packages 1226, 1232 may take the form of any of the examples of the IC package 1220 discussed above. The package-on-package structure 1234 may be configured in accordance with any of the package-on-package structures known in the art.

FIG. 13 is a block diagram of an example electrical device 1300 that may include one or more of the example glass-integrated inductors. For example, any suitable ones of the components of the electrical device 1300 may include one or more of the device assemblies 1200, IC devices 1000, or dies 902 disclosed herein, and may be arranged to include the example glass-integrated inductors. A number of components are illustrated in FIG. 13 as included in the electrical device 1300, but any one or more of these components may be omitted or duplicated, as suitable for the application. In some examples, some or all of the components included in the electrical device 1300 may be attached to one or more motherboards. In some examples, some or all of these components are fabricated onto a single system-on-a-chip (SoC) die.

Additionally, in various examples, the electrical device 1300 may not include one or more of the components illustrated in FIG. 13, but the electrical device 1300 may include interface circuitry for coupling to the one or more components. For example, the electrical device 1300 may not include a display 1306, but may include display interface circuitry (e.g., a connector and driver circuitry) to which a display 1306 may be coupled. In another set of examples, the electrical device 1300 may not include an audio input device 1324 (e.g., microphone) or an audio output device 1308 (e.g., a speaker, a headset, earbuds, etc.), but may include audio input or output device interface circuitry (e.g., connectors and supporting circuitry) to which an audio input device 1324 or audio output device 1308 may be coupled.

The electrical device 1300 may include programmable circuitry 1302 (e.g., one or more processing devices). The programmable circuitry 1302 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1300 may include a memory 1304, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 1304 may include memory that shares a die with the programmable circuitry 1302. This memory may be used as cache memory and may include embedded dynamic random access memory (eDRAM) or spin transfer torque magnetic random access memory (STT-MRAM).

In some examples, the electrical device 1100 may include a communication chip 1312 (e.g., one or more communication chips). For example, the communication chip 1312 may be configured for managing wireless communications for the transfer of data to and from the electrical device 1300. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 1312 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1312 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1312 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1312 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1312 may operate in accordance with other wireless protocols in other examples. The electrical device 1300 may include an antenna 1322 to facilitate wireless communications and/or to receive other wireless communications (such as AM or FM radio transmissions).

In some examples, the communication chip 1312 may manage wired communications, such as electrical, optical, or any other suitable communication protocols (e.g., the Ethernet). As noted above, the communication chip 1312 may include multiple communication chips. For instance, a first communication chip 1312 may be dedicated to shorter-range wireless communications such as Wi-Fi or Bluetooth, and a second communication chip 1312 may be dedicated to longer-range wireless communications such as global positioning system (GPS), EDGE, GPRS, CDMA, WiMAX, LTE, EV-DO, or others. In some examples, a first communication chip 1312 may be dedicated to wireless communications, and a second communication chip 1312 may be dedicated to wired communications.

The electrical device 1300 may include battery/power circuitry 1314. The battery/power circuitry 1314 may include one or more energy storage devices (e.g., batteries or capacitors) and/or circuitry for coupling components of the electrical device 1300 to an energy source separate from the electrical device 1300 (e.g., AC line power).

The electrical device 1300 may include a display 1306 (or corresponding interface circuitry, as discussed above). The display 1306 may include any visual indicators, such as a heads-up display, a computer monitor, a projector, a touchscreen display, a liquid crystal display (LCD), a light-emitting diode display, or a flat panel display.

The electrical device 1300 may include an audio output device 1108 (or corresponding interface circuitry, as discussed above). The audio output device 1108 may include any device that generates an audible indicator, such as speakers, headsets, or earbuds.

The electrical device 1300 may include an audio input device 1324 (or corresponding interface circuitry, as discussed above). The audio input device 1324 may include any device that generates a signal representative of a sound, such as microphones, microphone arrays, or digital instruments (e.g., instruments having a musical instrument digital interface (MIDI) output).

The electrical device 1300 may include a GPS circuitry 1318. The GPS circuitry 1318 may be in communication with a satellite-based system and may receive a location of the electrical device 1300, as known in the art.

The electrical device 1300 may include any other output device 1310 (or corresponding interface circuitry, as discussed above). Examples of the other output device 1310 may include an audio codec, a video codec, a printer, a wired or wireless transmitter for providing information to other devices, or an additional storage device.

The electrical device 1300 may include any other input device 1320 (or corresponding interface circuitry, as discussed above). Examples of the other input device 1320 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1300 may have any desired form factor, such as a hand-held or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device. In some examples, the electrical device 1300 may be any other electronic device that processes data.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities and/or steps, the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities and/or steps, the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements or method actions may be implemented by, e.g., the same entity or object. Additionally, although individual features may be included in different examples or claims, these may possibly be combined, and the inclusion in different examples or claims does not imply that a combination of features is not feasible and/or advantageous.

Example methods, apparatus, systems, and articles of manufacture to enable glass-integrated inductors are disclosed herein. Further examples and combinations thereof include the following:
Example 1 includes an integrated circuit (IC) package comprising a glass layer having an aperture extending therethrough, and an inductor in the aperture, the inductor including a metal core extending through the aperture, the metal core electrically coupled to interconnects on opposite sides of the glass layer, and at least one of a ferrite layer or a magnetic alloy layer in the aperture and laterally surrounding the metal core.
Example 2 includes the IC package as defined in example 1, wherein the at least one of the ferrite layer or the magnetic alloy layer includes a first ferrite layer in the aperture, and a second ferrite layer in the aperture, the second ferrite layer laterally surrounding the first ferrite layer.
Example 3 includes the IC package as defined in example 2, further including a dielectric layer at longitudinal ends of the first ferrite layer and the second ferrite layer.
Example 4 includes the IC package as defined in any of examples 2 or 3, further including a layer comprising a metal between the first ferrite layer and the second ferrite layer.
Example 5 includes the IC package as defined in any of examples 1 to 4, wherein the magnetic alloy layer is in the aperture, and further including a dielectric layer between the metal core and the magnetic alloy layer.
Example 6 includes the IC package as defined in example 5, wherein the dielectric layer contacts and surrounds the metal core.
Example 7 includes the IC package as defined in any of examples 5 or 6, wherein the dielectric layer contacts a longitudinal end of the at least one of the ferrite layer or the magnetic alloy layer.
Example 8 includes the IC package as defined in any of examples 1 to 7, wherein the ferrite layer is in the aperture and contacts the metal core.
Example 9 includes the IC package as defined in any of examples 1 to 8, wherein the at least one of the ferrite layer or the magnetic alloy layer includes at least one of iron, cobalt, nickel, oxygen, manganese, or a nickel-iron ferromagnetic alloy.
Example 10 includes a glass core for use with a semiconductor package, the glass core comprising a glass substrate, and an inductor at least partially extending through the glass substrate, the inductor including a conductive core, and at least one of a ferrite layer or a magnetic alloy layer laterally surrounding the conductive core.
Example 11 includes the glass core as defined in example 10, wherein the at least one of the ferrite layer or the magnetic alloy layer includes a first ferrite layer, and a second ferrite layer laterally surrounding the conductive core.
Example 12 includes the glass core as defined in example 11, wherein the first ferrite layer includes a first ferrite material that is different from a second ferrite material of the second ferrite layer.
Example 13 includes the glass core as defined in any of examples 10 to 12, wherein the at least one of the ferrite layer or the magnetic alloy layer includes the magnetic alloy layer with a dielectric layer positioned between the conductive core and the magnetic alloy layer.
Example 14 includes the glass core as defined in example 13, wherein the dielectric layer contacts and surrounds the conductive core.
Example 15 includes the glass core as defined in any of examples 13 or 14, wherein the dielectric layer extends to a longitudinal end of the at least one of the ferrite layer or the magnetic alloy layer.
Example 16 includes the glass core as defined in any of examples 13 to 15, wherein the inductor includes the magnetic alloy layer between the ferrite layer and the dielectric layer.
Example 17 includes the glass core as defined in any of examples 10 to 16, wherein the at least one of the ferrite layer or the magnetic alloy layer includes at least one of iron, cobalt, nickel, oxygen, manganese, or a nickel-iron ferromagnetic alloy.
Example 18 includes the glass core as defined in any of examples 10 to 17, wherein the glass substrate includes at least one of quartz, fused silica, or borosilicate glass.
Example 19 includes a method comprising defining an aperture in a glass substrate, providing a first metal layer onto walls of the aperture, providing at least one of a ferrite layer or a magnetic alloy layer onto the aperture, and providing a second metal layer to define a metal core that is laterally surrounded by the at least one of the ferrite layer or the magnetic alloy layer.
Example 20 includes the method as defined in example 19, wherein the ferrite layer is provided within the aperture, and further including providing a second ferrite layer within the aperture.

From the foregoing, it will be appreciated that example systems, methods, apparatus, and articles of manufacture have been disclosed that enable glass-integrated inductors for which parameters such as permeability and loss can be accurately controlled. Examples disclosed herein can also enable a glass-integrated inductor in which thicknesses of layers (e.g., diametric layers, lateral layers, etc.) can be controlled. Examples can also effectively provide inductive capabilities to IC packages while utilizing the benefits of glass core technology.

The following claims are hereby incorporated into this Detailed Description by this reference. Although certain example systems, methods, apparatus, and articles of manufacture have been disclosed herein, the scope of coverage of this patent is not limited thereto. On the contrary, this patent covers all systems, methods, apparatus, and articles of manufacture fairly falling within the scope of the claims of this patent.

## Claims

1. An integrated circuit (IC) package comprising:
a glass layer having an aperture extending therethrough; and
an inductor in the aperture, the inductor including:
a metal core extending through the aperture, the metal core electrically coupled to interconnects on opposite sides of the glass layer; and
at least one of a ferrite layer or a magnetic alloy layer in the aperture and laterally surrounding the metal core.

2. The IC package as defined in claim 1, wherein the at least one of the ferrite layer or the magnetic alloy layer includes:
a first ferrite layer in the aperture; and
a second ferrite layer in the aperture, the second ferrite layer laterally surrounding the first ferrite layer.

3. The IC package as defined in claim 2, further including a dielectric layer at longitudinal ends of the first ferrite layer and the second ferrite layer.

4. The IC package as defined in claim 2, further including a layer comprising a metal between the first ferrite layer and the second ferrite layer.

5. The IC package as defined in any of claims 1 to 4, wherein the magnetic alloy layer is in the aperture, and further including a dielectric layer between the metal core and the magnetic alloy layer.

6. The IC package as defined in claim 5, wherein the dielectric layer contacts and surrounds the metal core.

7. The IC package as defined in claim 5, wherein the dielectric layer contacts a longitudinal end of the at least one of the ferrite layer or the magnetic alloy layer.

8. The IC package as defined in any of claims 1 to 7, wherein the ferrite layer is in the aperture and contacts the metal core.

9. The IC package as defined in any of claims 1 to 8, wherein the at least one of the ferrite layer or the magnetic alloy layer includes at least one of iron, cobalt, nickel, oxygen, manganese, or a nickel-iron ferromagnetic alloy.

10. The IC package as defined in any of claims 1 to 9, wherein the at least one of the ferrite layer or the magnetic alloy layer includes the magnetic alloy layer with a dielectric layer positioned between the metal core and the magnetic alloy layer.

11. The IC package as defined in claim 10, wherein the dielectric layer contacts and surrounds the metal core.

12. The IC package as defined in any of claims 10 or 11, wherein the dielectric layer extends to a longitudinal end of the at least one of the ferrite layer or the magnetic alloy layer.

13. The IC package as defined in any of claims 10 to 12, wherein the inductor includes the magnetic alloy layer between the ferrite layer and the dielectric layer.

14. A method comprising:
defining an aperture in a glass substrate;
providing a first metal layer onto walls of the aperture;
providing at least one of a ferrite layer or a magnetic alloy layer onto the aperture; and
providing a second metal layer to define a metal core that is laterally surrounded by the at least one of the ferrite layer or the magnetic alloy layer.

15. The method as defined in claim 14, wherein the ferrite layer is provided within the aperture, and further including providing a second ferrite layer within the aperture.
